(19) Europäisches Patentamt / European Patent Office / Office européen des brevets

(11) **EP 3 227 998 B1**

(12) **EUROPEAN PATENT SPECIFICATION**

(45) Date of publication and mention of the grant of the patent:
**15.07.2020 Bulletin 2020/29**

(21) Application number: **14809342.0**

(22) Date of filing: **02.12.2014**

(51) Int Cl.:
*H03F 1/02* (2006.01)       *H03F 3/60* (2006.01)
*H03F 1/32* (2006.01)       *H03F 3/24* (2006.01)

(86) International application number:
**PCT/EP2014/076267**

(87) International publication number:
**WO 2016/086974 (09.06.2016 Gazette 2016/23)**

(54) **AN AMPLIFYING SYSTEM FOR AMPLIFYING A COMMUNICATION SIGNAL**

VERSTÄRKUNGSSYSTEM ZUR VERSTÄRKUNG EINES KOMMUNIKATIONSSIGNALS

SYSTÈME D'AMPLIFICATION PERMETTANT D'AMPLIFIER UN SIGNAL DE COMMUNICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**11.10.2017 Bulletin 2017/41**

(73) Proprietor: **Huawei Technologies Co., Ltd.**
**Longgang**
**Shenzhen, Guangdong 518129 (CN)**

(72) Inventors:
• **WONG, James**
  **164 40 Kista (SE)**
• **MARTIN, Francesc Purroy**
  **164 40 Kista (SE)**

(74) Representative: **Gill Jennings & Every LLP**
**SAH**
**The Broadgate Tower**
**20 Primrose Street**
**London EC2A 2ES (GB)**

(56) References cited:
**JP-A- 2006 203 673      US-A1- 2005 280 466**
**US-A1- 2013 229 234**

**Description**

TECHNICAL FIELD

The present invention relates to the field of communication signal amplification.

BACKGROUND

Modern wireless communication networks are increasingly designed to provide a high data rate and an improved data handling capacity to mobile devices within the wireless communication networks. Recent approaches towards increasing the data rate and improving the data handling capacity are based on employing communication signals having an increased peak-to-average power ratio (PAR) and/or an increased operational bandwidth. Moreover, techniques for carrier aggregation of the communication signals can be employed enabling a concurrent usage of different frequency bands for increasing the data rate.

For amplifying a communication signal, different types of amplifiers can be employed. For example, a Doherty amplifier can be used to amplify the communication signal, wherein the Doherty amplifier can be regarded as a modified class B amplifier. For providing carrier aggregation capabilities, at least two separate amplifiers are usually employed.

Current approaches, however, can suffer from a reduced efficiency when amplifying communication signals having a high peak-to-average power ratio (PAR) and/or a high operational bandwidth, and may suffer from a reduced efficiency when applying a carrier aggregation technique.

JP2006203673 relates to an amplifying system for amplifying a communication signal in accordance with the preamble of claim 1.

SUMMARY

It is an object of the invention to provide an efficient concept for amplifying a communication signal.

This object is achieved by the features of the independent claims. Further implementation forms are apparent from the dependent claims, the description and the figures.

Embodiments of the present invention are based on the finding that a primary amplifier, a secondary amplifier, and an auxiliary amplifier can be employed in order to amplify the communication signal, wherein the primary amplifier and the secondary amplifier can operate according to a Chireix out-phasing amplifier architecture, and wherein the auxiliary amplifier can operate to complement the operation of the primary amplifier and the secondary amplifier.

The communication signal can be decomposed into a lower portion communication signal indicating magnitudes of the communication signal below a predetermined threshold, and an upper portion communication signal indicating magnitudes of the communication signal above the predetermined threshold. The lower portion communication signal can further be decomposed into a first lower portion communication sub-signal and a second lower portion communication sub-signal having constant magnitudes.

The primary amplifier can be configured to perform an amplification based on the first lower portion communication sub-signal, the secondary amplifier can be configured to perform an amplification based on the second lower portion communication sub-signal, and the auxiliary amplifier can be configured to perform an amplification based on the upper portion communication signal. The amplified signals can then be combined in order to provide the amplified communication signal.

The concept can be applied to amplify any communication signal. In particular, the concept can be applied to amplify communication signals having a high peak-to-average power ratio (PAR) and/or a high operational bandwidth, such as multi-carrier communication signals used in long term evolution (LTE) wireless communication networks.

According to a first aspect, the invention relates to an amplifying system for amplifying a communication signal, the amplifying system comprising a processor being configured to compare magnitudes of the communication signal with a predetermined threshold, and to decompose the communication signal into a lower portion communication signal and an upper portion communication signal upon the basis of the predetermined threshold, wherein the lower portion communication signal indicates magnitudes of the communication signal below the predetermined threshold, and wherein the upper portion communication signal indicates magnitudes of the communication signal above the predetermined threshold, wherein the processor is further configured to decompose the lower portion communication signal into a first lower portion communication sub-signal and a second lower portion communication sub-signal, the first lower portion communication sub-signal and the second lower portion communication sub-signal respectively having constant magnitudes, a primary amplifier being configured to amplify a first amplifier signal derived from (e.g. which is based on) the first lower portion communication sub-signal to obtain a first amplified lower portion communication sub-signal, a secondary amplifier being configured to amplify a second amplifier signal derived from (e.g. which is based on) the second lower portion communication sub-signal to obtain a second amplified lower portion communication sub-signal, an auxiliary amplifier being configured to amplify a third amplifier signal derived from (e.g. which is based on) the upper portion communication signal to obtain an amplified upper portion communication signal, and a combiner being configured to combine the first amplified lower portion communication sub-signal with the second amplified lower portion communication sub-signal to obtain an amplified lower portion communication signal, and to combine the amplified lower portion communication signal with the amplified upper portion communication signal to obtain an amplified communication signal. Thus, an efficient concept for amplifying a communication signal can be realized.

The primary amplifier, the secondary amplifier, and the auxiliary amplifier can be radio frequency (RF) amplifiers. The primary amplifier and the secondary amplifier can form a Chireix out-phasing amplifier. The primary amplifier and the secondary amplifier can be identical. The decomposition of the lower portion communication signal can be a Chireix out-phasing decomposition.

The communication signal, the lower portion communication signal, the first lower portion communication sub-signal, the second lower portion communication sub-signal, and the upper portion communication signal can be baseband signals. The first amplifier signal, the second amplifier signal, the third amplifier signal, the first amplified lower portion communication sub-signal, the second amplified lower portion communication sub-signal, the amplified upper portion communication signal, and the amplified communication signal can be radio frequency (RF) signals.

The magnitudes of the communication signal can be normalized with regard to a predetermined magnitude interval, e.g. the interval [0; 1]. The predetermined threshold can be a real number, e.g. 0.3 or 0.7.

The processor is configured to filter the lower portion communication signal upon the basis of a transfer function of the primary amplifier and/or a transfer function of the secondary amplifier to obtain a filtered lower portion communication signal, to subtract the filtered lower portion communication signal from the lower portion communication signal to obtain an error signal, and to add the error signal to the upper portion communication signal. Thus, a compensation of the upper portion communication signal with regard to the transfer function of the primary amplifier and/or the transfer function of the secondary amplifier can be realized.

In a first implementation form of the amplifying system according to the first aspect, the processor is configured to determine out-phase angles upon the basis of the lower portion communication signal, the out-phase angles indicating ratios between magnitudes of the lower portion communication signal and a maximum magnitude of the lower portion communication signal, wherein the processor is configured to add the out-phase angles to phase angles of the lower portion communication signal to obtain phase angles of the first lower portion communication sub-signal, and wherein the processor is configured to subtract the out-phase angles from the phase angles of the lower portion communication signal to obtain phase angles of the second lower portion communication sub-signal. Thus, a Chireix out-phasing decomposition can be performed efficiently.

The processor can provide the first lower portion communication sub-signal and the second lower portion communication sub-signal as a pair of signals having constant magnitudes or envelopes. The phase angle difference of the first lower portion communication sub-signal and the second lower portion communication sub-signal can be optimized, e.g. reduced.

In a second implementation form of the amplifying system according to the first aspect as such or any preceding implementation form of the first aspect, the amplifying system further comprises a local oscillator, a first mixer, a second mixer, and an third mixer, wherein the local oscillator is configured to generate a carrier signal, wherein the first mixer is configured to multiply the first lower portion communication sub-signal by the carrier signal to obtain the first amplifier signal, wherein the second mixer is configured to multiply the second lower portion communication sub-signal by the carrier signal to obtain the second amplifier signal, and wherein the third mixer is configured to multiply the upper portion communication signal by the carrier signal to obtain the third amplifier signal. Thus, an up-mixing of the first lower portion communication sub-signal, the second lower portion communication sub-signal, and the upper portion communication signal can be realized.

The local oscillator can comprise a phase-locked loop (PLL). The carrier signal can be a radio frequency (RF) signal.

The first mixer can comprise a first image-rejection filter. The multiplication of the first lower portion communication sub-signal by the carrier signal can be performed in an analogue signal domain. The amplifying system can comprise a first digital-to-analogue converter (DAC) for converting the first lower portion communication sub-signal from a digital signal domain into the analogue signal domain.

The second mixer can comprise a second image-rejection filter. The multiplication of the second lower portion communication sub-signal by the carrier signal can be performed in an analogue signal domain. The amplifying system can comprise a second digital-to-analogue converter (DAC) for converting the second lower portion communication sub-signal from a digital signal domain into the analogue signal domain.

The third mixer can comprise a third image-rejection filter. The multiplication of the upper portion communication signal by the carrier signal can be performed in an analogue signal domain. The amplifying system can comprise a third digital-to-analogue converter (DAC) for converting the upper portion communication signal from a digital signal domain into the analogue signal domain.

In a third implementation form of the amplifying system according to the first aspect as such or any preceding implementation form of the first aspect, the combiner comprises a first quarter-wavelength transmission line and a second quarter-wavelength transmission line to combine the first amplified lower portion communication sub-signal with the second amplified lower portion communication sub-signal. Thus, an impedance transformation can be realized efficiently.

The first quarter-wavelength transmission line and the second quarter-wavelength transmission line can form a Chireix out-phasing combiner.

In a fourth implementation form of the amplifying system according to the first aspect as such or any preceding implementation form of the first aspect, the combiner comprises a directional coupler to combine the amplified lower portion communication signal with the amplified upper portion communication signal. Thus, the amplified lower portion communication signal and the amplified upper portion communication signal can be combined efficiently.

The amplified lower portion communication signal and the amplified upper portion communication signal can be combined by the directional coupler with regard to a predetermined coupling ratio C.

In a fifth implementation form of the amplifying system according to the first aspect as such or any preceding implementation form of the first aspect, the primary amplifier or the secondary amplifier is a class AB amplifier or a class B amplifier. Thus, the primary amplifier or the secondary amplifier can be realized efficiently.

In a sixth implementation form of the amplifying system according to the first aspect as such or any preceding implementation form of the first aspect, the auxiliary amplifier is a class AB amplifier, a class B amplifier, or a class C amplifier. Thus, the auxiliary amplifier can be realized efficiently. The auxiliary amplifier can be a single-ended amplifier.

In a seventh implementation form of the amplifying system according to the first aspect as such or any preceding implementation form of the first aspect, the primary amplifier, the secondary amplifier, or the auxiliary amplifier comprises a pair of amplifying elements, wherein the pair of amplifying elements is connected in parallel. Thus, the operational bandwidth of the amplifying system can be improved. The pair of amplifying elements can be connected in a push-pull configuration.

In an eighth implementation form of the amplifying system according to the first aspect as such or any preceding implementation form of the first aspect, the amplifying system further comprises an auxiliary directional coupler being configured to derive a reference signal from the amplified communication signal, wherein the processor is configured to compare the upper portion communication signal with a comparison signal derived from the reference signal to determine a time delay between the upper portion communication signal and the comparison signal, and to delay the upper portion communication signal in time upon the basis of the time delay. Thus, an alignment of peaks of the upper portion communication signal and the amplified communication signal in time can be realized.

The comparison signal can be a baseband signal. The reference signal can be a radio frequency (RF) signal. The time delay can e.g. be determined upon the basis of a cross-correlation between the upper portion communication signal and the comparison signal.

In a ninth implementation form of the amplifying system according to the eighth implementation form of the first aspect, the amplifying system further comprises a local oscillator and an auxiliary mixer, wherein the local oscillator is configured to generate a carrier signal, and wherein the auxiliary mixer is configured to multiply the reference signal by the carrier signal to obtain the comparison signal. Thus, a down-mixing of the reference signal can be realized.

The local oscillator can comprise a phase-locked loop (PLL). The carrier signal can be a radio frequency (RF) signal.

The auxiliary mixer can comprise an auxiliary image-rejection filter. The multiplication of the reference signal by the carrier signal can be performed in an analogue signal domain. The amplifying system can comprise an analogue-to-digital converter (ADC) for converting the comparison signal from the analogue signal domain into a digital signal domain.

In an tenth implementation form of the amplifying system according to the first aspect as such or any preceding implementation form of the first aspect, the processor is configured to inversely filter the upper portion communication signal upon the basis of a transfer function of the primary amplifier, a transfer function of the secondary amplifier, and/or a transfer function of the auxiliary amplifier. Thus, a digital pre-distortion (DPD) can be realized.

The transfer function of the primary amplifier, the transfer function of the secondary amplifier, and/or the transfer function of the auxiliary amplifier can be combined in order to perform the inverse filtering.

In a eleventh implementation form of the amplifying system according to the first aspect as such or any preceding implementation form of the first aspect, the processor is configured to initiate a reduction of a supply voltage of the primary amplifier and/or the secondary amplifier. Thus, an output power of the primary amplifier and/or the secondary amplifier can be limited.

The reduction of the supply voltage may e.g. be applied in reduced traffic conditions.

In a twelfth implementation form of the amplifying system according to the first aspect as such or any preceding implementation form of the first aspect, the processor is configured to initiate a deactivation of the auxiliary amplifier. Thus, the amplifying system can operate as a Chireix out-phasing amplifier.

The deactivation of the auxiliary amplifier can provide an improved efficiency of the amplifying system in reduced traffic conditions.

According to a second aspect, the invention relates to a method for amplifying a communication signal, the method comprising comparing magnitudes of the communication signal with a predetermined threshold, decomposing the communication signal into a lower portion communication signal and an upper portion communication signal upon the basis of the predetermined threshold, wherein the lower portion communication signal indicates magnitudes of the communication signal below the predetermined threshold, and wherein the upper portion communication signal indicates magnitudes of the communication signal above the predetermined threshold, decomposing the lower portion communication signal into a first lower portion communication sub-signal and a second lower portion communication sub-signal, the first lower portion communication sub-signal and the second lower portion communication sub-signal respectively having constant magnitudes, amplifying a first amplifier signal derived from the first lower portion communication sub-signal to obtain a first amplified lower portion communication sub-signal, amplifying a second amplifier signal derived from the second lower portion communication sub-signal to obtain a second amplified lower portion communication sub-signal, amplifying a third amplifier signal derived from the upper portion communication signal to obtain an amplified upper portion communication signal, combining the first amplified lower portion communication sub-signal with the second amplified lower portion communication sub-signal to obtain an amplified lower portion communication signal, and combining the amplified lower portion communication signal with the amplified upper portion communication signal to obtain an amplified communication signal. Thus, an efficient concept for amplifying a communication signal can be realized.

The method can be performed by the amplifying system. Further features of the method can directly result from the functionality of the amplifying system.

The method further includes filtering the lower portion communication signal upon the basis of a transfer function of the primary amplifier or a transfer function of the secondary amplifier for obtaining a filtered lower portion communication signal, subtracting the filtered lower portion communication signal from the lower portion communication signal for obtaining an error signal, and adding the error signal to the upper portion communication signal.

According to a third aspect, the invention relates to a computer program comprising a program code which, when the program is executed on a computer, causes the computer to carry out the method. Thus, the method can be performed automatically.

The amplifying system, e.g. the processor of the amplifying system, can be programmably arranged to execute the computer program.

Embodiments of the present invention can be implemented in hardware and/or software.

SHORT DESCRIPTION OF THE FIGURES

Embodiments of the invention will be described with respect to the following figures, in which:

Fig. 1 shows a diagram of an amplifying system for amplifying a communication signal according to an embodiment;

Fig. 2 shows a diagram of a method for amplifying a communication signal according to an embodiment;

Fig. 3 shows a diagram of an amplifying system for amplifying a communication signal according to an embodiment;

Fig. 4 shows a diagram of an amplifying system for amplifying a communication signal according to an embodiment;

Fig. 5 shows a diagram of an amplifying system for amplifying a communication signal according to an embodiment;

Fig. 6 shows diagrams of decomposing a communication signal into a lower portion communication signal and an upper portion communication signal according to an embodiment;

Fig. 7 shows a diagram of phase angles of a first lower portion communication sub-signal and a second lower portion communication sub-signal according to an embodiment;

Fig. 8 shows diagrams of decomposing a communication signal into a lower portion communication signal and an upper portion communication signal according to an embodiment;

Fig. 9 shows diagrams of magnitudes and phase angles of a first lower portion communication sub-signal and a second lower portion communication sub-signal according to an embodiment;

Fig. 10 shows a diagram of a primary amplifier, a secondary amplifier, and a Chireix out-phasing combiner according to an embodiment;

Fig. 11 shows a diagram of powers of a primary amplifier, a secondary amplifier and an auxiliary amplifier according to an embodiment;

Fig. 12 shows diagrams of a coupling loss, an output back-off, and an amplifier power ratio of an amplifying system according to an embodiment;

Fig. 13 shows diagrams of load-pull ratios within an amplifying system according to an embodiment; and

Fig. 14 shows a diagram of efficiencies of an amplifying system according to an embodiment.

DETAILED DESCRIPTION OF EMBODIMENTS

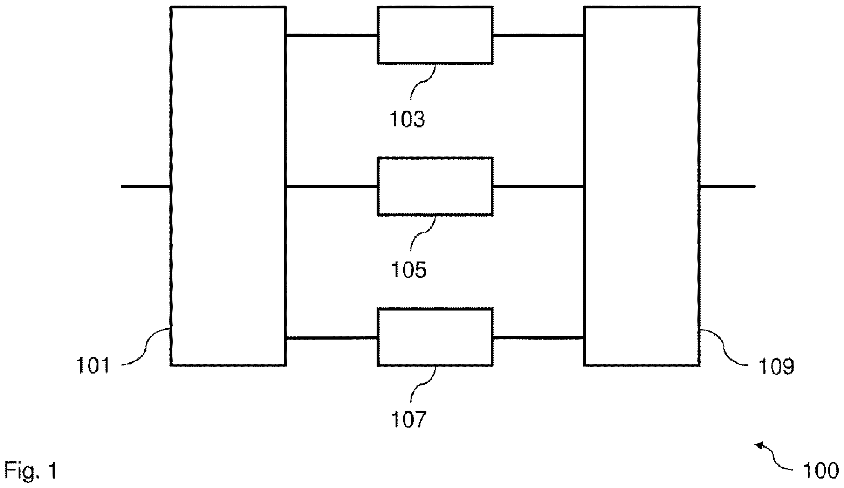

Fig. 1 shows a diagram of an amplifying system 100 for amplifying a communication signal according to an embodiment.
The amplifying system 100 comprises a processor 101 being configured to compare magnitudes of the communication signal with a predetermined threshold, and to decompose the communication signal into a lower portion communication signal and an upper portion communication signal upon the basis of the predetermined threshold. The lower portion communication signal indicates magnitudes of the communication signal below the predetermined threshold. The upper portion communication signal indicates magnitudes of the communication signal above the predetermined threshold. The processor 101 is further configured to decompose the lower portion communication signal into a first lower portion communication sub-signal and a second lower portion communication sub-signal, the first lower portion communication sub-signal and the second lower portion communication sub-signal respectively having constant magnitudes.
The amplifying system 100 further comprises a primary amplifier 103 being configured to amplify a first amplifier signal derived from the first lower portion communication sub-signal to obtain a first amplified lower portion communication sub-signal.
The amplifying system 100 further comprises a secondary amplifier 105 being configured to amplify a second amplifier signal derived from the second lower portion communication sub-signal to obtain a second amplified lower portion communication sub-signal.
The amplifying system 100 further comprises an auxiliary amplifier 107 being configured to amplify a third amplifier signal derived from the upper portion communication signal to obtain an amplified upper portion communication signal.
Furthermore, the amplifying system 100 comprises a combiner 109 being configured to combine the first amplified lower portion communication sub-signal with the second amplified lower portion communication sub-signal to obtain an amplified lower portion communication signal, and to combine the amplified lower portion communication signal with the amplified upper portion communication signal to obtain an amplified communication signal.
In an embodiment, the amplifying system 100 further comprises a local oscillator, a first mixer, a second mixer, and an third mixer, wherein the local oscillator is configured to generate a carrier signal, wherein the first mixer is configured to multiply the first lower portion communication sub-signal by the carrier signal to obtain the first amplifier signal, wherein the second mixer is configured to multiply the second lower portion communication sub-signal by the carrier signal to obtain the second amplifier signal, and wherein the third mixer is configured to multiply the upper portion communication signal by the carrier signal to obtain the third amplifier signal.
In an embodiment, the primary amplifier 103 or the secondary amplifier 105 is a class AB amplifier or a class B amplifier. In an embodiment, the auxiliary amplifier 107 is a class AB amplifier, a class B amplifier, or a class C amplifier.

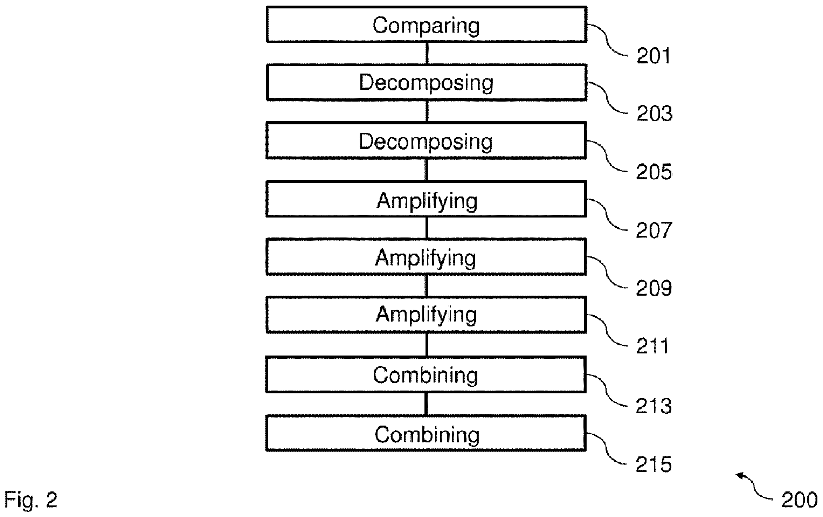

Fig. 2 shows a diagram of a method 200 for amplifying a communication signal according to an embodiment.
The method 200 comprises comparing 201 magnitudes of the communication signal with a predetermined threshold, decomposing 203 the communication signal into a lower portion communication signal and an upper portion communication signal upon the basis of the predetermined threshold, wherein the lower portion communication signal indicates magnitudes of the communication signal below the predetermined threshold, and wherein the upper portion communication signal indicates magnitudes of the communication signal above the predetermined threshold, decomposing 205 the lower portion communication signal into a first lower portion communication sub-signal and a second lower portion communication sub-signal, the first lower portion communication sub-signal and the second lower portion communication sub-signal respectively having constant magnitudes, amplifying 207 a first amplifier signal derived from the first lower portion communication sub-signal to obtain a first amplified lower portion communication sub-signal, amplifying 209 a second amplifier signal derived from the second lower portion communication sub-signal to obtain a second amplified lower portion communication sub-signal, amplifying 211 a third amplifier signal derived from the upper portion communication signal to obtain an amplified upper portion communication signal, combining 213 the first amplified lower portion communication sub-signal with the second amplified lower portion communication sub-signal to obtain an amplified lower portion communication signal, and combining 215 the amplified lower portion communication signal with the amplified upper portion communication signal to obtain an amplified communication signal. The method 200 can be performed by the amplifying system 100.

In the following, further implementation forms and embodiments of the amplifying system 100 and the method 200 will be described.

As the demand for higher data rates increases, the desire for an increased data handling capacity may be addressed by mobile service operators. The approach of increasing the power spectral density of communication signals may no longer be appealing since mobile service operators can own and/or share frequency spectra within allocated frequency bands. As an example, taking E-UTRA band 2, e.g. from 1930 to 1990 MHz, and band 4, e.g. from 2110 to 2155 MHz, a mobile service operator may own and/or share frequency spectra at 1970 to 1990 MHz and 2110 to 2120 MHz. Two separate transmitters can be deployed for this purpose. As power increases, the desire for an improved efficiency can increase in order to reduce the weight and size of thermal heat-sinks. This desire can further be exacerbated by a higher PAR of the communication signals in order to accommodate higher data rates.

In summary, an efficient and wideband approach, being sufficient to cover at least two frequency spectra, can be desired in order to address the specifications for an improved data handling capacity. A hybrid combination of a Chireix amplifier architecture and a Doherty amplifier architecture can be applied as an efficient approach of extending a POBO of an amplifying system. A Chireix out-phasing architecture can further be applied, allowing communication signal amplification across a wider range of frequencies.

The approaches can rely on actively loading amplifiers during operation. As such, the load VSWR of the amplifiers can become larger than two. Larger load VSWR ratios can limit the frequency bandwidth the amplifying system can operate on, despite yielding high efficiencies. Furthermore, crest factor values of up to 9dB or more can be typical for communication signals. Efficient amplification with these levels of crest factors can desire that an amplifier can achieve good efficiency performance at large back-off power levels.

A high efficiency at low power levels can be achieved using a specific type of amplifier by load-pulling the output impedance of the different transistors that can compose the amplifier. There can be three consequences of load-pulling.

Firstly, the drain efficiency of the transistors depends on the load-pull ratio. If, as a reference, a load is assumed that gives maximum power, then a maximum efficiency load appears at a 2:1 load-pull ratio and further load-pulling reduces the drain efficiency. Secondly, the bandwidth of the amplifiers sustains a given efficiency and depends on the load-pulling, wherein greater load pulling can give less bandwidth. Thirdly, the load-pull defines a back-off performance of the amplifier. More load-pulling can an efficiency maximum at lower power levels leading to more back-off.

It is desired that the amplifiers keep a maximum efficiency from $-\infty$ dB to 0dB in case the average efficiency with a modulated communication signal is equal to the power amplifier maximum efficiency. In practice, a high efficiency may only be achieved in some power ranges and for that reason the achieved efficiency may not be equal to the maximum transistor efficiency. It is convenient to select the power range according to the statistical probability density function of the communication signal which will be transmitted.

High efficiency benefits, despite a high load VSWR and reduced bandwidths, of the mentioned approaches can be further taken advantage of by introducing a sequential portion to its operation. This allows a reduced load VSWR to be deployed, thus enabling wider bandwidths to be supported. It can further allow the amplifying system to support variable PARs of the communication signals with maximum efficiencies at the desired POBO.

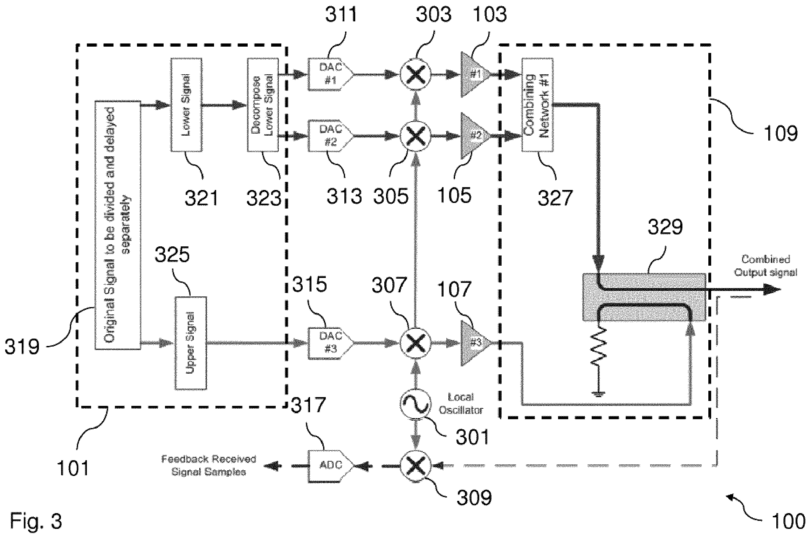

Fig. 3 shows a diagram of an amplifying system 100 for amplifying a communication signal according to an embodiment. The amplifying system 100 is structured according to a sequential Chireix out-phasing amplifier architecture. The amplifying system 100 forms a possible implementation of the amplifying system 100 as described in conjunction with Fig. 1.

The amplifying system 100 comprises a processor 101, a primary amplifier 103, a secondary amplifier 105, an auxiliary amplifier 107, and a combiner 109. The amplifying system 100 further comprises a local oscillator 301, a first mixer 303, a second mixer 305, a third mixer 307, an auxiliary mixer 309, a first digital-to-analogue converter (DAC) 311, a second digital-to-analogue converter (DAC) 313, a third digital-to-analogue converter (DAC) 315, and an analogue-to-digital converter (ADC) 317.

The local oscillator 301 can be configured to generate a carrier signal. The first mixer 303 is be configured to multiply a first lower portion communication sub-signal provided by the processor 101 by the carrier signal to obtain the first amplifier signal. The second mixer 305 is configured to multiply a second lower portion communication sub-signal provided by the processor 101 by the carrier signal to obtain a second amplifier signal. The third mixer 307 is configured to multiply the upper portion communication signal provided by the processor 101 by the carrier signal to obtain a third amplifier signal.

An auxiliary directional coupler, which is not shown in the figure, can be configured to derive a reference signal from the amplified communication signal, wherein the processor 101 can be configured to compare the upper portion communication signal with a comparison signal derived from the reference signal to determine a time delay between the upper portion communication signal and the comparison signal, and to delay the upper portion communication signal in time upon the basis of the time delay. The auxiliary mixer 309 can be configured to multiply the reference signal by the carrier signal to obtain the comparison signal.

The first digital-to-analogue converter (DAC) 311 is configured to convert the first lower portion communication sub-signal from a digital signal domain into an analogue signal domain. The second digital-to-analogue converter (DAC) 313 is configured to convert the second lower portion communication sub-signal from a digital signal domain into an analogue signal domain. The third digital-to-analogue converter (DAC) 315 is configured to convert the upper portion communication signal from a digital signal domain into an analogue signal domain. The analogue-to-digital converter (ADC) 317 is configured to convert the comparison signal from an analogue signal domain into a digital signal domain.

The processor 101 comprises a communication signal provider 319, a lower portion communication signal provider 321, a lower portion communication signal decomposer 323, and an upper portion communication signal provider 325. The communication signal provider 319 provides the original communication signal to be decomposed, e.g. divided, and delayed separately. The lower portion communication signal provider 321 provides the lower portion communication signal. The lower portion communication signal decomposer 323 decomposes the lower portion communication signal into the first lower portion communication sub-signal and the second lower portion communication sub-signal. The upper portion communication signal provider 325 provides the upper portion communication signal.

The combiner 109 can comprise a Chireix out-phasing combiner 327, and a directional coupler 329. The Chireix out-phasing combiner 327 can comprise a first quarter-wavelength transmission line and a second quarter-wavelength transmission line to combine the first amplified lower portion communication sub-signal provided by the first amplifier 103 with the second amplified lower portion communication sub-signal provided by the second amplifier 105. The directional coupler 329 can be configured to combine the amplified lower portion communication signal provided by the combiner 327 with the amplified upper portion communication signal provided by the auxiliary amplifier 107.

The amplifying system 100 can be based on adapting the concept of a sequential amplifier architecture and a Chireix outphasing amplifier architecture into a hybrid combination of both. The primary amplifier 103 and the secondary amplifier 105, e.g. transistor devices, can form an out-phasing pair of amplification whilst the combiner 109, e.g. the Chireix out-phasing combiner 327, can perform a Chireix active combination of the amplified signals. The auxiliary amplifier 107, e.g. transistor device, can perform an auxiliary signal restoration and enhancement to the overall injected communication signal.

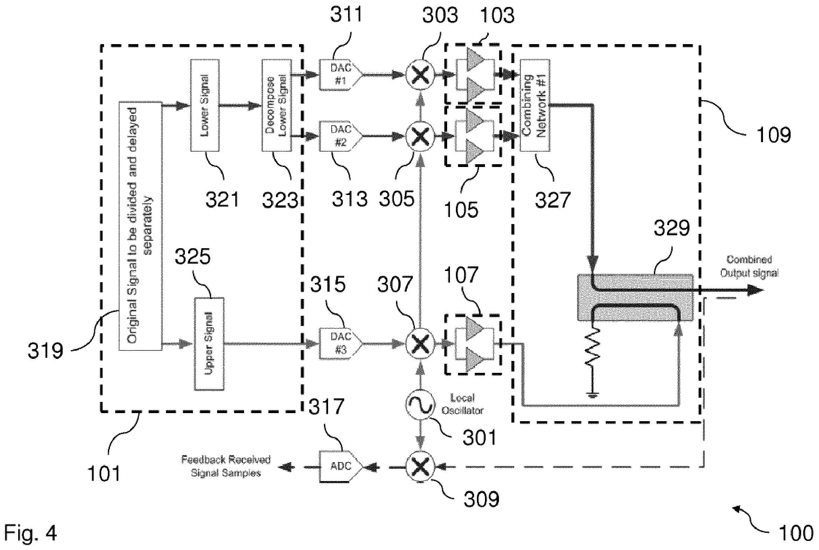

Fig. 4 shows a diagram of an amplifying system 100 for amplifying a communication signal according to an embodiment. The diagram illustrates an architecture of the amplifying system 100 comprising push-pull amplifying elements. The amplifying system 100 forms a possible implementation of the amplifying system 100 as described in conjunction with Fig. 1.

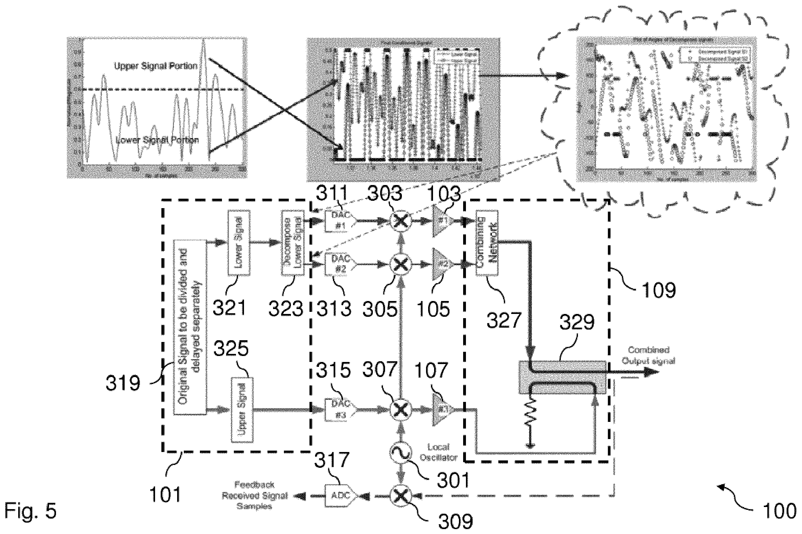

The amplifying system 100 shown in Fig. 5 differs from the amplifying system 100 shown in Fig. 4 in that the amplifiers 103, 105, 107 are each implemented as a parallel pair of amplifying elements.

In other words, the primary amplifier 103 comprises a pair of amplifying elements, wherein the pair of amplifying elements is connected in parallel between an input and an output of the primary amplifier 103. The secondary amplifier 105 comprises a pair of amplifying elements, wherein the pair of amplifying elements is connected in parallel between an input and an output of the secondary amplifier 105. The auxiliary amplifier 107 comprises a pair of amplifying elements, wherein the pair of amplifying elements is connected in parallel between an input and an output of the auxiliary amplifier 107.

As can be seen in Fig. 4, for enhancing an operation bandwidth of the amplifying system 100 the individual amplifiers 103, 105, 107 can be replaced with smaller equivalents, e.g. the amplifying elements, arranged in a push-pull configuration. Smaller amplifying elements can inherently offer smaller reactances, and when configured in a push-pull arrangement, the output power to reactance ratio can be doubled compared with a single-ended larger amplifier. This arrangement can therefore allow a further improvement of the operational bandwidth.

Fig. 5 shows a diagram of the amplifying system 100 shown in Fig. 3 together with three diagrams that illustrate how the original intended communication signal for amplification is decomposed into two separate portions, i.e. the upper portion communication signal and the lower portion communication signal by the processor 101. The lower portion communication signal can further be decomposed into respective constant magnitude or constant envelope sub-signals, i.e. the first lower portion communication sub-signal and the second lower portion communication sub-signal, prior to being amplified. The upper portion communication signal can be fed into the sequential peaking section, i.e. the auxiliary amplifier 107.

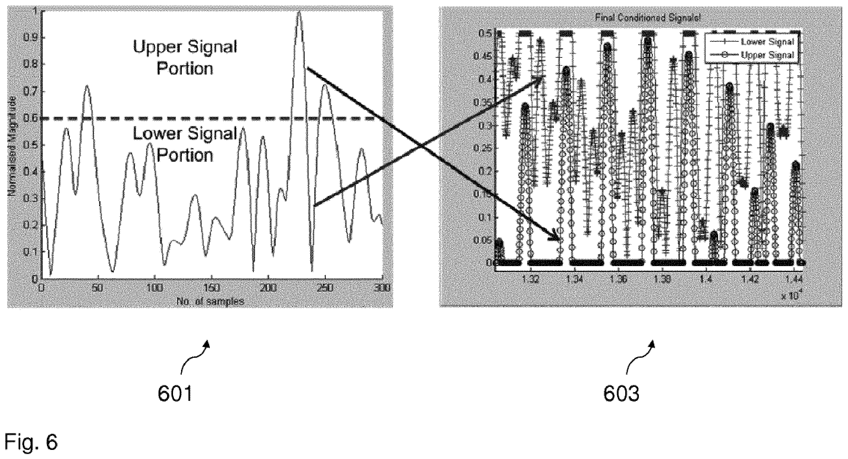

Fig. 6 shows the first two diagrams of Fig. 5 in more detail.

Fig. 6 shows diagrams 601, 603 of decomposing a communication signal into a lower portion communication signal and an upper portion communication signal according to an embodiment. The diagrams 601, 603 illustrate a decomposition of a long term evolution (LTE) communication signal having an operational bandwidth of 10 MHz.

The left diagram 601 shows a normalized magnitude of the communication signal over a sample index. The predetermined threshold is indicated as horizontal dashed line. The right diagram 603 shows normalized magnitudes of the lower portion communication signal and the upper portion communication signal over an offset and scaled sample index.

The predetermined threshold indicated by the horizontal dashed line separates the communication signal into the upper portion communication signal and the lower portion communication signal and can be determined upon the basis of the communication signal PAR and/or POBO of the Chireix outphasing section according to the following equation:

$$\text{Threshold Level} = 10^{[(POBO - PAR)/20]}$$

In this example, the PAR of the communication signal is 9dB and the POBO of the communication signal is 5.9dB, leading to a predetermined threshold of 0.7.

In an embodiment, the following routine, e.g. for-loop, is used in order to decompose the communication signal into the lower portion communication signal and the upper portion communication signal or to apply the predetermined threshold:

```
For n = 1:length(signal),
    if abs[signal(n)] < threshold;
            low_signal(n) = abs[signal(n)]
            upp_signal(n) = 0
    else
            low_signal(n) = threshold
            upp_signal(n) = abs[signal(n)] - threshold
    endif
    end
```

wherein signal denotes the communication signal, low_signal denotes the lower portion communication signal, upp_signal denotes the upper portion communication signal, threshold denotes the predetermined threshold, and n denotes the sample index.

In an embodiment, the decomposition of the communication signal into the lower portion communication signal and the upper portion communication signal is performed such that the communication signal is the sum of the lower portion communication signal and the upper portion communication signal.

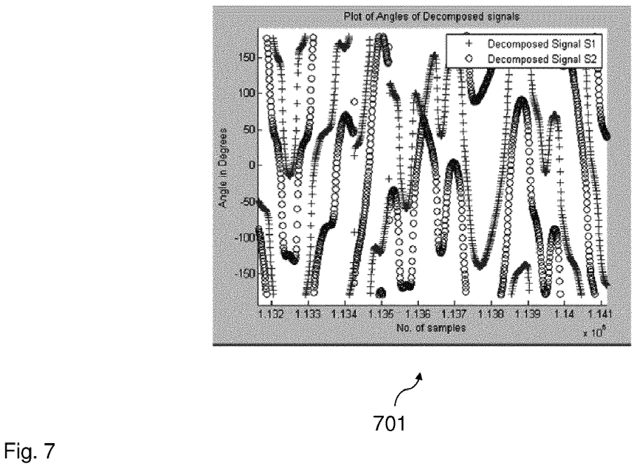

Fig. 7 shows the diagram of Fig. 5 in more detail.

Fig. 7 shows a diagram 701 of phase angles of a first lower portion communication sub-signal and a second lower portion communication sub-signal according to an embodiment.

The diagram 701 shows the phase angles of the first lower portion communication sub-signal and the second lower portion communication sub-signal over a sample index. The crosses indicate the phase angles of the first lower portion communication sub-signal. The circles indicate the phase angles of the second lower portion communication sub-signal.

In an embodiment, the decomposition of the lower portion communication signal into the first lower portion communication sub-signal and the second lower portion communication sub-signal having constant magnitudes or envelopes is performed according to the following equations:

$$\theta = \text{arccosine}\{A(t)/\max[A(t)]\},$$

$$\Phi = \text{arctangent}\{\text{Imaginary}[A(t)]/\text{Real}[A(t)]\}$$

$$S1 = \{\max[A(t)]/2\} \times [\text{cosine}(\Phi + \theta) + j \sin(\Phi + \theta)]$$

$$S2 = \{\max[A(t)]/2\} \times [\text{cosine}(\Phi - \theta) + j \sin(\Phi - \theta)]$$

wherein $\theta$ denotes an out-phase angle, $\Phi$ denotes a data angle, A(t) denotes the lower portion communication signal as baseband signal comprising real and imaginary components, S1 denotes the first lower portion communication sub-signal, and S2 denotes the second lower portion communication sub-signal.

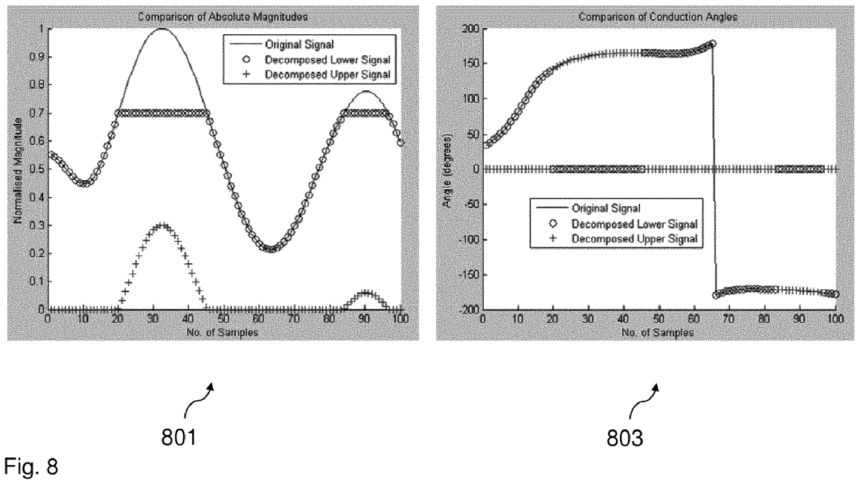

Fig. 8 shows diagrams 801, 803 of decomposing a communication signal into a lower portion communication signal and an upper portion communication signal according to an embodiment.

The left diagram 801 shows normalized magnitudes of the communication signal, the lower portion communication signal and the upper portion communication signal over a sample index. The right diagram 803 shows conduction angles of the communication signal, the lower portion communication signal and the upper portion communication signal over the sample index. The solid line indicates the communication signal. The circles indicate the lower portion communication signal. The crosses indicate the upper portion communication signal.

The decomposition can break the original communication signal into two separate signals, i.e. the lower portion communication signal and the upper portion communication signal, upon the basis of the predetermined threshold. In this example, the predetermined threshold level is at 0.7.

The decomposed signals, i.e. the lower portion communication signal and the upper portion communication signal, can show reduced levels of magnitude, thereby reducing an amount of voltage and/or current swing of the active amplifiers, and reduced conduction angles, e.g. no longer conduction angles of ±180° but ±90°.

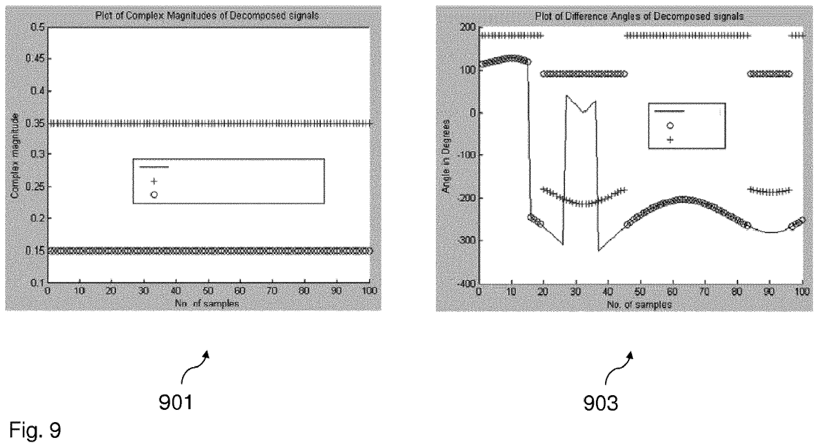

Fig. 9 shows diagrams 901, 903 of magnitudes and phase angles of a first lower portion communication sub-signal and a second lower portion communication sub-signal according to an embodiment.

The left diagram 901 shows normalized complex magnitudes of the lower portion communication signal, the first lower portion communication sub-signal and the second lower portion communication sub-signal over a sample index. The right diagram 903 shows phase angles of the lower portion communication signal, the first lower portion communication sub-signal and the second lower portion communication sub-signal over the sample index. The phase angles can indicate difference angles. The solid line indicates the lower portion communication signal. The circles indicate the first lower portion communication sub-signal. The crosses indicate the second lower portion communication sub-signal.

In an embodiment, the decomposition of the lower portion communication signal into the first lower portion communication sub-signal and the second lower portion communication sub-signal having constant magnitudes or envelopes is performed by the processor 101 according to the following equations:

$$\theta = \text{arccosine}\{A(t)/\max[A(t)]\},$$

$$\Phi = \text{arctangent}\{\text{Imaginary}[A(t)]/\text{Real}[A(t)]\}$$

$$S1 = \{\max[A(t)]/2\} \times [\text{cosine}(\Phi + \theta) + j\,\text{sine}(\Phi + \theta)]$$

$$S2 = \{\max[A(t)]/2\} \times [\text{cosine}(\Phi - \theta) + j\,\text{sine}(\Phi - \theta)]$$

$$\text{Difference Angle} = \text{angle}(S1) - \text{angle}(S2)$$

wherein $\theta$ denotes an out-phase angle, $\Phi$ denotes a data angle, $A(t)$ denotes the lower portion communication signal as baseband signal comprising real and imaginary components, S1 denotes the first lower portion communication sub-signal, and S2 denotes the second lower portion communication sub-signal.

It can follow, with the equations above, that resultant conduction angles based on the decomposed signals, i.e. the first lower portion communication sub-signal and the second lower portion communication sub-signal, can be reduced compared with the original non-decomposed lower portion communication signal. For example, in the period of 20 to 45 samples, the original non-decomposed lower portion communication signal can have a deviation of 360° whilst the decomposed signals, i.e. the first lower portion communication sub-signal and the second lower portion communication sub-signal, may only have deviations less than 45°.

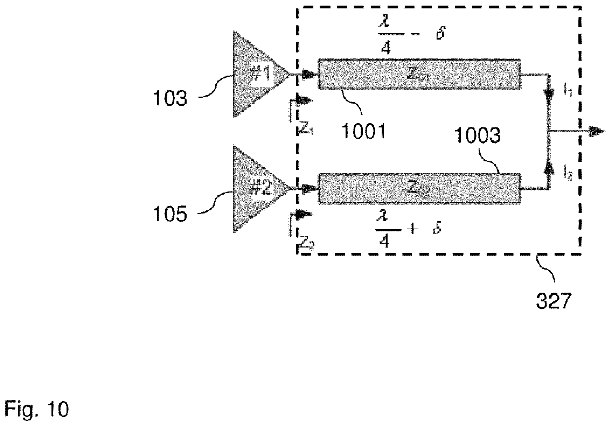

Fig. 10 shows a diagram of a primary amplifier 103, a secondary amplifier 105, and a Chireix out-phasing combiner 327 according to an embodiment. The Chireix out-phasing combiner 327 comprises a first quarter-wavelength transmission line 1001 and a second quarter-wavelength transmission line 1003. The diagram illustrates a section of the amplifying system 100 realizing a Chireix out-phasing.

The following equation can define impedances seen by the respective primary amplifier 103, e.g. active transistor device, and secondary amplifier 105, e.g. active transistor device, during operation:

$$Z_n = Z_{On} \frac{Z_n + jZ_{On}\tan\left(\frac{\pi}{2}-\theta\right)}{Z_{On}+jZ_n\tan\left(\frac{\pi}{2}-\theta\right)} = Z_{On}\frac{Z_n\tan\theta+jZ_{On}}{Z_{On}\tan\theta+jZ_n}$$

At maximum power, the respective impedances, $Z_1$ and $Z_2$, as seen by currents $I_1$ and $I_2$ can eventually become the same as the characteristic impedances of the lines $Z_{O1}$ and $Z_{O2}$.

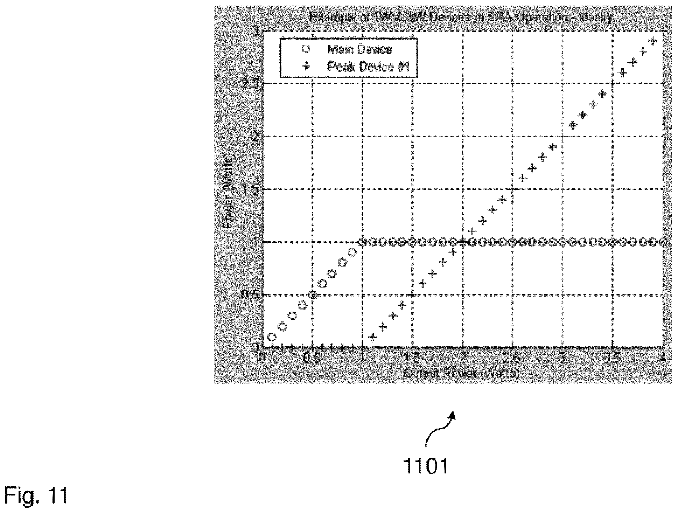

Fig. 11 shows a diagram 1101 of powers of a primary amplifier 103, a secondary amplifier 105 and an auxiliary amplifier 107 according to an embodiment. The diagram 1101 illustrates a sequential operation of the amplifying system 100. The primary amplifier 103 and the secondary amplifier 105 can form a main device. The auxiliary amplifier 107 can form a peaking or peak device.

An exemplary 1W main device, e.g. primary amplifier 103 and secondary amplifier 105, and an exemplary 3W peak device, e.g. auxiliary amplifier 107, are used to illustrate the sequential operation. The main device can be driven to a maximum output power of 1W indicated by circles on the Y-axis where it can deliver a maximum efficiency. At this instance, the peak device can begin to turn on as indicated by crosses on the Y-axis. A maximum power of 4W can eventually be achieved when both the main device and the peak device are delivering their maximum output powers, respectively.

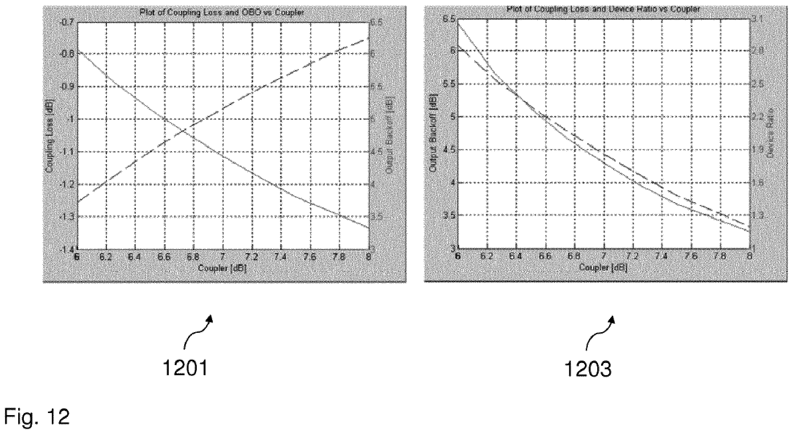

Fig. 12 shows diagrams 1201, 1203 of a coupling loss, an output back-off, and an amplifier power ratio of an amplifying system 100 according to an embodiment. The diagrams 1201, 1203 illustrate a relationship between the coupling loss, the output back-off, and the amplifier power ratio or size in dependence of a coupling ratio of a directional coupler, e.g. the directional coupler 329.

In the amplifying system 100, the primary amplifier 103 and the secondary amplifier 105 can form a Chireix out-phasing amplification section. The auxiliary amplifier 107 can be a single-ended class AB, class B, or class C amplifier. The directional coupler 329 can be of any arbitrary coupling ratio C. However, due considerations may be taken in account in order to reach an optimum resolution of the auxiliary amplifier size, losses and back-off capabilities.

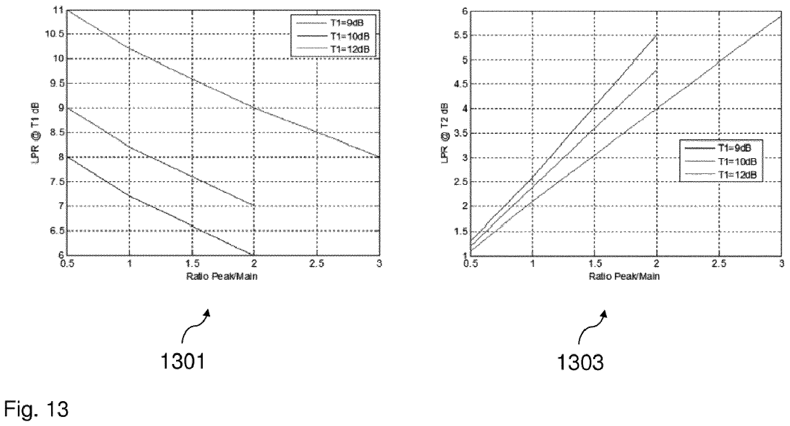

Fig. 13 shows diagrams 1301, 1303 of load-pull ratios within an amplifying system 100 according to an embodiment. The diagrams 1301, 1303 further illustrate a relationship between efficiency points T1, T2 and the load-pull ratios.

A specific architecture, e.g. the Chireix-Doherty architecture, can select a starting point of a high efficiency range, point T1, and a further point T2, which can be determined upon the basis of a combination of the amplifier power ratio size and the position of the point T1. The position of the point T1 can determine a load-pull ratio of the amplifiers. That can imply the efficiency at point T1 and a maximum operational bandwidth that may be achieved.

It can be observed that the load-pull ratio at point T2 may not be zero dB as it can be in a stand-alone Chireix amplifier pair. This non-zero load-pull ratio at point T2 may limit the achievable operational bandwidth for a given back-off efficiency in the specific architecture. The load-pull ratio at point T2 can be 0 dB. This can allow a reduction of the load-pull ratio at point T1 which can mean that wider operational bandwidths can be achieved with the same position of point T1 with the same back-off efficiency.

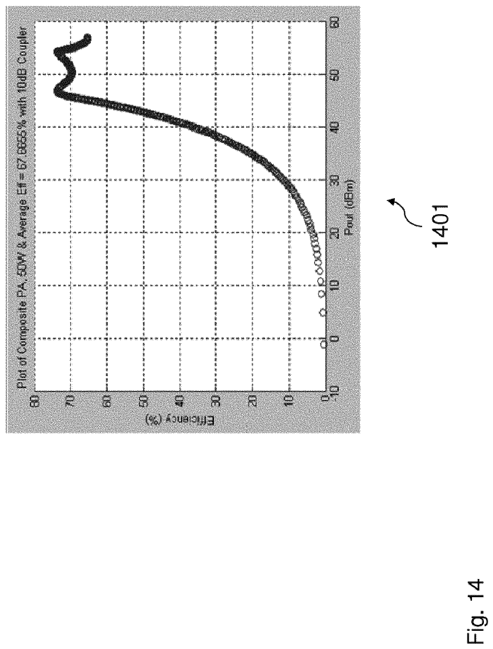

Fig. 14 shows a diagram 1401 of efficiencies of an amplifying system 100 according to an embodiment. The diagram 1401 illustrates an efficiency characteristic of the amplifying system 100. The efficiency characteristic is shown for operation within the confines of operating frequency bandwidth limits. The amplifying system 100 provides a power of 50 W and an average efficiency of 67.6655 % using a directional coupler of 10 dB coupling ratio.

The following table provides a performance summary of different architectures. A 10dB PAR long term evolution (LTE) communication signal is used to estimate and simulate an average efficiency performance of the architectures. An average power of 50W using amplifiers capable of delivering a maximum available efficiency of 81.78% is stipulated in this example, thus enabling a comparative view of the architectures.

| | Class AB/B/F | Chireix Doherty* | Chireix* | Sequential Chireix Outphasing* |
|---|---|---|---|---|
| Average Efficiency | 8.2% | 81% | 69.45% | 67.7% |
| Load VSWR | 1:1 | 1:6.6 | 1:10 | 1:4 |
| * Idealised efficiency calculations without accounting for interaction losses due to a load VSWR impact; a higher load VSWR can tend towards higher losses | | | | |

In an implementation form, the amplifying system 100 enables a wideband operation with high efficiencies upon the basis of a Chireix out-phasing approach. This can e.g. be achieved by a composite sequential architecture that can allow a reduced load VSWR to be presented to the primary amplifier 103 and/or the secondary amplifier 105, thus allowing a wider bandwidth of operation. An additional feature can be the fact that it can further support a variable POBO.

Throughout the description, the following definitions of acronyms and glossaries is used: PAR denotes peak-to-average power ratio, VSWR denotes voltage standing wave ratio, TX denotes transmit, RX a receive, SRX denotes sampling receive, POBO denotes power output back-off, DPD denotes digital pre-distortion, DAC denotes digital-to-analogue converter, ADC denotes analogue-to-digital converter, LTE denotes long term evolution, SPA denotes sequential power amplifier, CSA denotes composite sequential amplifier, LTCC denotes low temperature co-fired ceramics, E-UTRA denotes evolved UMTS terrestrial radio access, and UMTS denotes universal mobile telecommunications system.

**Claims**

1. An amplifying system (100) for amplifying a communication signal, the amplifying system (100) comprising:

   a processor (101) being configured to compare magnitudes of the communication signal with a predetermined threshold, and to decompose the communication signal into a lower portion communication signal and an upper portion communication signal upon the basis of the predetermined threshold, wherein the lower portion communication signal indicates magnitudes of the communication signal below the predetermined threshold, and wherein the upper portion communication signal indicates magnitudes of the communication signal above the predetermined threshold, wherein the processor (101) is further configured to decompose the lower portion communication signal into a first lower portion communication sub-signal and a second lower portion communication sub-signal, the first lower portion communication sub-signal and the second lower portion communication sub-signal respectively having constant magnitudes;
   a primary amplifier (103) being configured to amplify a first amplifier signal derived from the first lower portion communication sub-signal to obtain a first amplified lower portion communication sub-signal;
   a secondary amplifier (105) being configured to amplify a second amplifier signal derived from the second lower portion communication sub-signal to obtain a second amplified lower portion communication sub-signal;
   an auxiliary amplifier (107) being configured to amplify a third amplifier signal derived from the upper portion communication signal to obtain an amplified upper portion communication signal; and
   a combiner (109) being configured to combine the first amplified lower portion communication sub-signal with the second amplified lower portion communication sub-signal to obtain an amplified lower portion communication signal, and to combine the amplified lower portion communication signal with the amplified upper portion communication signal to obtain an amplified communication signal;
   **characterised in that** the processor (101) is configured to filter the lower portion communication signal upon the basis of a transfer function of the primary amplifier (103) or a transfer function of the secondary amplifier (105) to obtain a filtered lower portion communication signal, to subtract the filtered lower portion communication signal from the lower portion communication signal to obtain an error signal, and to add the error signal to the upper portion communication signal.

2. The amplifying system (100) of claim 1, wherein the processor (101) is configured to determine out-phase angles upon the basis of the lower portion communication signal, the out-phase angles indicating ratios between magnitudes of the lower portion communication signal and a maximum magnitude of the lower portion communication signal, wherein the processor (101) is configured to add the out-phase angles to phase angles of the lower portion communication signal to obtain phase angles of the first lower portion communication sub-signal, and wherein the processor (101) is configured to subtract the out-phase angles from the phase angles of the lower portion communication signal to obtain phase angles of the second lower portion communication sub-signal.

3. The amplifying system (100) of any of the preceding claims, further comprising a local oscillator (301), a first mixer (303), a second mixer (305), and an third mixer (307), wherein the local oscillator (301) is configured to generate a carrier signal, wherein the first mixer (303) is configured to multiply the first lower portion communication sub-signal by the carrier signal to obtain the first amplifier signal, wherein the second mixer (305) is configured to multiply the second lower portion communication sub-signal by the carrier signal to obtain the second amplifier signal, and wherein the third mixer (307) is configured to multiply the upper portion communication signal by the carrier signal to obtain the third amplifier signal.

4. The amplifying system (100) of any of the preceding claims, wherein the combiner (109) comprises a first quarter-wavelength transmission line (1001) and a second quarter-wavelength transmission line (1003) to combine the first amplified lower portion communication sub-signal with the second amplified lower portion communication sub-signal.

5. The amplifying system (100) of any of the preceding claims, wherein the combiner (109) comprises a directional coupler (329) to combine the amplified lower portion communication signal with the amplified upper portion communication signal.

6. The amplifying system (100) of any of the preceding claims, wherein the primary amplifier (103) or the secondary amplifier (105) is a class AB amplifier or a class B amplifier.

7. The amplifying system (100) of any of the preceding claims, wherein the auxiliary amplifier (107) is a class AB amplifier, a class B amplifier, or a class C amplifier.

8. The amplifying system (100) of any of the preceding claims, wherein the primary amplifier (103), the secondary amplifier (105), or the auxiliary amplifier (107) comprises a pair of amplifying elements, and wherein the pair of amplifying elements is connected in parallel.

9. The amplifying system (100) of any of the preceding claims, further comprising an auxiliary directional coupler being configured to derive a reference signal from the amplified communication signal, wherein the processor (101) is configured to compare the upper portion communication signal with a comparison signal derived from the reference signal to determine a time delay between the upper portion communication signal and the comparison signal, and to delay the upper portion communication signal in time upon the basis of the time delay.

10. The amplifying system (100) of claim 9, further comprising a local oscillator (301) and an auxiliary mixer (309), wherein the local oscillator (301) is configured to generate a carrier signal, and wherein the auxiliary mixer (309) is configured to multiply the reference signal by the carrier signal to obtain the comparison signal.

11. The amplifying system (100) of any of the preceding claims, wherein the processor (101) is configured to inversely filter the upper portion communication signal upon the basis of a transfer function of the primary amplifier (103), a transfer function of the secondary amplifier (105), or a transfer function of the auxiliary amplifier (107).

12. The amplifying system (100) of any of the preceding claims, wherein the processor (101) is configured to initiate a reduction of a supply voltage of the primary amplifier (103) or the secondary amplifier (105).

13. The amplifying system (100) of any of the preceding claims, wherein the processor (101) is configured to initiate a deactivation of the auxiliary amplifier (107).

14. A method (200) for amplifying a communication signal, the method (200) comprising:

comparing (201) magnitudes of the communication signal with a predetermined threshold;
decomposing (203) the communication signal into a lower portion communication signal and an upper portion communication signal upon the basis of the predetermined threshold, wherein the lower portion communication signal indicates magnitudes of the communication signal below the predetermined threshold, and wherein the upper portion communication signal indicates magnitudes of the communication signal above the predetermined threshold;
decomposing (205) the lower portion communication signal into a first lower portion communication sub-signal and a second lower portion communication sub-signal, the first lower portion communication sub-signal and the second lower portion communication sub-signal respectively having constant magnitudes;
amplifying (207) a first amplifier signal derived from the first lower portion communication sub-signal to obtain a first amplified lower portion communication sub-signal;
amplifying (209) a second amplifier signal derived from the second lower portion communication sub-signal to obtain a second amplified lower portion communication sub-signal;
amplifying (211) a third amplifier signal derived from the upper portion communication signal to obtain an amplified upper portion communication signal;
combining (213) the first amplified lower portion communication sub-signal with the second amplified lower portion communication sub-signal to obtain an amplified lower portion communication signal; and
combining (215) the amplified lower portion communication signal with the amplified upper portion communication signal to obtain an amplified communication signal;
**characterised in that** the method further comprises: filtering the lower portion communication signal upon the basis of a transfer function of the primary amplifier or a transfer function of the secondary amplifier for obtaining a filtered lower portion communication signal, subtracting the filtered lower portion communication signal from the lower portion communication signal for obtaining an error signal, and adding the error signal to the upper portion communication signal.

15. A computer program comprising a program code which, when the program is executed on a computer, causes the computer to carry out the method claimed in claim 14.


**Patentansprüche**

1. Verstärkungssystem (100) zum Verstärken eines Kommunikationssignals, das Verstärkungssystem (100) Folgendes umfassend:

einen Prozessor (101), der eingerichtet ist, um Stärken des Kommunikationssignals mit einem vorbestimmten Schwellenwert zu vergleichen und das Kommunikationssignal auf der Grundlage des vorbestimmten Schwellenwerts in einen unteren Kommunikationssignalabschnitt und in einen oberen Kommunikationssignalabschnitt zu zerlegen, wobei der untere Kommunikationssignalabschnitt Stärken des Kommunikationssignals unter dem vorbestimmten Schwellenwert angibt und wobei der obere Kommunikationssignalabschnitt Stärken des Kommunikationssignals oberhalb des vorbestimmten Schwellenwerts angibt, wobei der Prozessor (101) weiterhin eingerichtet ist, um den unteren Kommunikationssignalabschnitt in einen ersten unteren Kommunikationssubsignalabschnitt und in einen zweiten unteren Kommunikationssubsignalabschnitt zu zerlegen, wobei der erste untere Kommunikationssubsignalabschnitt bzw. der zweite untere Kommunikationssubsignalabschnitt konstante Stärken aufweisen;
einen primären Verstärker (103), der eingerichtet ist, um ein erstes Verstärkersignal zu verstärken, das aus dem ersten unteren Kommunikationssubsignalabschnitt abgeleitet wurde, um einen ersten verstärkten unteren Kommunikationssubsignalabschnitt zu erhalten;
einen sekundären Verstärker (105), der eingerichtet ist, um ein zweites Verstärkersignal zu verstärken, das aus dem zweiten unteren Kommunikationssubsignalabschnitt abgeleitet wurde, um einen zweiten verstärkten unteren Kommunikationssubsignalabschnitt zu erhalten;
einen Hilfsverstärker (107), der eingerichtet ist, um ein drittes Verstärkersignal zu verstärken, das aus dem oberen Kommunikationssignalabschnitt abgeleitet wurde, um einen verstärkten oberen Kommunikationssignalabschnitt zu erhalten; und
einen Kombinator (109), der eingerichtet ist, um den ersten verstärkten unteren Kommunikationssubsignalabschnitt mit dem zweiten verstärkten unteren Kommunikationssubsignalabschnitt zu kombinieren, um einen verstärkten unteren Kommunikationssignalabschnitt zu erhalten, und um den verstärkten unteren Kommunikationssignalabschnitt mit dem verstärkten oberen Kommunikationssignalabschnitt zu kombinieren, um ein verstärktes Kommunikationssignal zu erhalten;
**dadurch gekennzeichnet, dass**
der Prozessor (101) eingerichtet ist, um den unteren Kommunikationssignalabschnitt auf der Grundlage einer Transferfunktion des primären Verstärkers (103) oder einer Transferfunktion des sekundären Verstärkers (105) zu filtern, um einen gefilterten unteren Kommunikationssignalabschnitt zu erhalten, um den gefilterten unteren Kommunikationssignalabschnitt von dem unteren Kommunikationssignalabschnitt zu subtrahieren, um ein Fehlersignal zu erhalten, und um das Fehlersignal zu dem oberen Kommunikationssignalabschnitt zu addieren.

2. Verstärkungssystem (100) nach Anspruch 1, wobei der Prozessor (101) eingerichtet ist, um Außerphasenwinkel auf der Grundlage des unteren Kommunikationssignalabschnitts zu bestimmen, wobei die Außerphasenwinkel Verhältnisse zwischen Stärken des unteren Kommunikationssignalabschnitts und einer maximalen Stärke des unteren Kommunikationssignalabschnitts angeben, wobei der Prozessor (101) eingerichtet ist, um die Außerphasenwinkel zu Phasenwinkeln des unteren Kommunikationssignalabschnitts zu addieren, um Phasenwinkel des ersten unteren Kommunikationssubsignalabschnitts zu erhalten, und wobei der Prozessor (101) eingerichtet ist, um die Außerphasenwinkel von den Phasenwinkeln des unteren Kommunikationssignalabschnitts zu subtrahieren, um Phasenwinkel des zweiten unteren Kommunikationssubsignalabschnitts zu erhalten.

3. Verstärkungssystem (100) nach einem der vorhergehenden Ansprüche, weiterhin umfassend einen Lokaloszillator (301), einen ersten Mischer (303), einen zweiten Mischer (305) und einen dritten Mischer (307), wobei der Lokaloszillator (301) eingerichtet ist, um ein Trägersignal zu erzeugen, wobei der erste Mischer (303) eingerichtet ist, um den ersten unteren Kommunikationssubsignalabschnitt mit dem Trägersignal zu multiplizieren, um das erste Verstärkersignal zu erhalten, wobei der zweite Mischer (305) eingerichtet ist, um den zweiten unteren Kommunikationssubsignalabschnitt mit dem Trägersignal zu multiplizieren, um das zweite Verstärkersignal zu erhalten, und wobei der dritte Mischer (307) eingerichtet ist, um den oberen Kommunikationssignalabschnitt mit dem Trägersignal zu multiplizieren, um das dritte Verstärkersignal zu erhalten.

4. Verstärkungssystem (100) nach einem der vorhergehenden Ansprüche, wobei der Kombinator (109) eine erste Viertelwellenübertragungsleitung (1001) und eine zweite Viertelwellenübertragungsleitung (1003) umfasst, um den ersten verstärkten unteren Kommunikationssubsignalabschnitt mit dem zweiten verstärkten unteren Kommunikationssubsignalabschnitt zu kombinieren.

5. Verstärkungssystem (100) nach einem der vorhergehenden Ansprüche, wobei der Kombinator (109) einen Richtkoppler (329) umfasst, um den verstärkten unteren Kommunikationssignalabschnitt mit dem verstärkten oberen Kommunikationssignalabschnitt zu kombinieren.

6. Verstärkungssystem (100) nach einem der vorhergehenden Ansprüche, wobei der primäre Verstärker (103) oder der sekundäre Verstärker (105) ein Verstärker der Klasse AB oder ein Verstärker der Klasse B ist.

7. Verstärkungssystem (100) nach einem der vorhergehenden Ansprüche, wobei der Hilfsverstärker (107) ein Verstärker der Klasse AB, ein Verstärker der Klasse B oder ein Verstärker der Klasse C ist.

8. Verstärkungssystem (100) nach einem der vorhergehenden Ansprüche, wobei der primäre Verstärker (103), der sekundäre Verstärker (105) oder der Hilfsverstärker (107) ein Paar Verstärkungselemente umfasst, und wobei das Paar Verstärkungselemente parallelgeschaltet ist.

9. Verstärkungssystem (100) nach einem der vorhergehenden Ansprüche, weiterhin umfassend einen Hilfsrichtkoppler, der eingerichtet ist, um ein Referenzsignal aus dem verstärkten Kommunikationssignal abzuleiten, wobei der Prozessor (101) eingerichtet ist, um den oberen Kommunikationssignalabschnitt mit einem Vergleichssignal zu vergleichen, das aus dem Referenzsignal abgeleitet wurde, um eine Zeitverzögerung zwischen dem oberen Kommunikationssignalabschnitt und dem Vergleichssignal zu bestimmen und den oberen Kommunikationssignalabschnitt auf der Grundlage der Zeitverzögerung zeitlich zu verzögern.

10. Verstärkungssystem (100) nach Anspruch 9, weiterhin umfassend einen Lokaloszillator (301) und einen Hilfsmischer (309), wobei der Lokaloszillator (301) eingerichtet ist, um ein Trägersignal zu erzeugen, und wobei der Hilfsmischer (309) eingerichtet ist, um das Referenzsignal mit dem Trägersignal zu multiplizieren, um das Vergleichssignal zu erhalten.

11. Verstärkungssystem (100) nach einem der vorhergehenden Ansprüche, wobei der Prozessor (101) eingerichtet ist, um den oberen Kommunikationssignalabschnitt auf der Grundlage einer Transferfunktion des primären Verstärkers (103), einer Transferfunktion des sekundären Verstärkers (105) oder einer Transferfunktion des Hilfsverstärkers (107) invers zu filtern.

12. Verstärkungssystem (100) nach einem der vorhergehenden Ansprüche, wobei der Prozessor (101) eingerichtet ist, um eine Reduktion einer Versorgungsspannung des primären Verstärkers (103) oder des sekundären Verstärkers (105) zu veranlassen.

13. Verstärkungssystem (100) nach einem der vorhergehenden Ansprüche, wobei der Prozessor (101) eingerichtet ist, um eine Deaktivierung des Hilfsverstärkers (107) zu veranlassen.

14. Verfahren (200) zum Verstärken eines Kommunikationssignals, das Verfahren (200) Folgendes umfassend:

Vergleichen (201) von Stärken des Kommunikationssignals mit einem vorbestimmten Schwellenwert;
Zerlegen (203) des Kommunikationssignals in einen unteren Kommunikationssignalabschnitt und einen oberen Kommunikationssignalabschnitt auf der Grundlage des vorbestimmten Schwellenwerts, wobei der untere Kommunikationssignalabschnitt Stärken des Kommunikationssignals unter dem vorbestimmten Schwellenwert angibt und wobei der obere Kommunikationssignalabschnitt Stärken des Kommunikationssignals oberhalb des vorbestimmten Schwellenwerts angibt;
Zerlegen (205) des unteren Kommunikationssignalabschnitts in einen ersten unteren Kommunikationssubsignalabschnitt und einen zweiten unteren Kommunikationssubsignalabschnitt, wobei der erste untere Kommunikationssubsignalabschnitt bzw. der zweite untere Kommunikationssubsignalabschnitt konstante Stärken aufweisen;

Verstärken (207) eines ersten Verstärkersignals, das aus dem ersten unteren Kommunikationssubsignalabschnitt abgeleitet wurde, um einen ersten verstärkten unteren Kommunikationssubsignalabschnitt zu erhalten;

Verstärken (209) eines zweiten Verstärkersignals, das aus dem zweiten unteren Kommunikationssubsignalabschnitt abgeleitet wurde, um einen zweiten verstärkten unteren Kommunikationssubsignalabschnitt zu erhalten;

Verstärken (211) eines dritten Verstärkersignals, das aus dem oberen Kommunikationssignalabschnitt abgeleitet wurde, um einen verstärkten oberen Kommunikationssignalabschnitt zu erhalten;

Kombinieren (213) des ersten verstärkten unteren Kommunikationssubsignalabschnitts mit dem zweiten verstärkten unteren Kommunikationssubsignalabschnitt, um einen verstärkten unteren Kommunikationssignalabschnitt zu erhalten; und

Kombinieren (215) des verstärkten unteren Kommunikationssignalabschnitts mit dem verstärkten oberen Kommunikationssignalabschnitt, um ein verstärktes Kommunikationssignal zu erhalten;

**dadurch gekennzeichnet, dass** das Verfahren weiterhin Folgendes umfasst:

Filtern des unteren Kommunikationssignalabschnitts auf der Grundlage einer Transferfunktion des primären Verstärkers oder einer Transferfunktion des sekundären Verstärkers zum Erhalten eines gefilterten unteren Kommunikationssignalabschnitts, Subtrahieren des gefilterten unteren Kommunikationssignalabschnitts von dem unteren Kommunikationssignalabschnitt zum Erhalten eines Fehlersignals und Addieren des Fehlersignals zu dem oberen Kommunikationssignalabschnitt.

15. Computerprogramm, umfassend einen Programmcode, der, wenn das Programm auf einem Computer ausgeführt wird, bewirkt, dass der Computer das Verfahren nach Anspruch 14 ausführt.

**Revendications**

1. Système d'amplification (100) destiné à amplifier un signal de communication, le système d'amplification (100) comprenant :

un processeur (101) configuré pour comparer des amplitudes du signal de communication à un seuil prédéterminé, et pour décomposer le signal de communication en un signal de communication de partie inférieure et un signal de communication de partie supérieure sur la base du seuil prédéterminé, dans lequel le signal de communication de partie inférieure indique les amplitudes du signal de communication inférieures au seuil prédéterminé, et dans lequel le signal de communication de partie supérieure indique les amplitudes du signal de communication supérieures au seuil prédéterminé, dans lequel le processeur (101) est en outre configuré pour décomposer le signal de communication de partie inférieure en un premier sous-signal de communication de partie inférieure et un second sous-signal de communication de partie inférieure, le premier sous-signal de communication de partie inférieure et le second sous-signal de communication de partie inférieure présentant respectivement des amplitudes constantes ;

un amplificateur principal (103) configuré pour amplifier un premier signal d'amplificateur dérivé du premier sous-signal de communication de partie inférieure pour obtenir un premier sous-signal de communication de partie inférieure amplifié ;

un amplificateur secondaire (105) configuré pour amplifier un deuxième signal d'amplificateur dérivé du second sous-signal de communication de partie inférieure pour obtenir un second sous-signal de communication de partie inférieure amplifié ;

un amplificateur auxiliaire (107) configuré pour amplifier un troisième signal d'amplificateur dérivé du signal de communication de partie supérieure pour obtenir un signal de communication de partie supérieure amplifié ; et

un combineur (109) configuré pour combiner le premier sous-signal de communication de partie inférieure amplifié et le second sous-signal de communication de partie inférieure amplifié pour obtenir un signal de communication de partie inférieure amplifié, et pour combiner le signal de communication de partie inférieure amplifié et le signal de communication de partie supérieure amplifié pour obtenir un signal de communication amplifié ;

**caractérisé en ce que**

le processeur (101) est configuré pour filtrer le signal de communication de partie inférieure sur la base d'une fonction de transfert de l'amplificateur principal (103) ou d'une fonction de transfert de l'amplificateur secondaire (105) pour obtenir un signal de communication de partie inférieure filtré, pour soustraire le signal de communication de partie inférieure filtré du signal de communication de partie inférieure pour obtenir un signal d'erreur, et pour ajouter le signal d'erreur au signal de communication de partie supérieure.

2. Système d'amplification (100) selon la revendication 1, dans lequel le processeur (101) est configuré pour déterminer des angles hors phase sur la base du signal de communication de partie inférieure, les angles hors phase indiquant des rapports entre des amplitudes du signal de communication de partie inférieure et une amplitude maximale du signal de communication de partie inférieure, dans lequel le processeur (101) est configuré pour ajouter les angles hors phase à des angles de phase du signal de communication de partie inférieure pour obtenir des angles de phase du premier sous-signal de communication de partie inférieure, et dans lequel le processeur (101) est configuré pour soustraire les angles hors phase des angles de phase du signal de communication de partie inférieure pour obtenir des angles de phase du second sous-signal de communication de partie inférieure.

3. Système d'amplification (100) selon l'une quelconque des revendications précédentes, comprenant en outre un oscillateur local (301), un premier mélangeur (303), un deuxième mélangeur (305) et un troisième mélangeur (307), dans lequel l'oscillateur local (301) est configuré pour générer un signal de porteuse, dans lequel le premier mélangeur (303) est configuré pour multiplier le premier sous-signal de communication de partie inférieure par le signal de porteuse pour obtenir le premier signal d'amplificateur, dans lequel le deuxième mélangeur (305) est configuré pour multiplier le second sous-signal de communication de partie inférieure par le signal de porteuse pour obtenir le deuxième signal d'amplificateur, et dans lequel le troisième mélangeur (307) est configuré pour multiplier le signal de communication de partie supérieure par le signal de porteuse pour obtenir le troisième signal d'amplificateur.

4. Système d'amplification (100) selon l'une quelconque des revendications précédentes, dans lequel le combineur (109) comprend une première ligne de transmission en quart d'onde (1001) et une seconde ligne de transmission en quart d'onde (1003) pour combiner le premier sous-signal de communication de partie inférieure amplifié et le second sous-signal de communication de partie inférieure amplifié.

5. Système d'amplification (100) selon l'une quelconque des revendications précédentes, dans lequel le combineur (109) comprend un coupleur directionnel (329) pour combiner le signal de communication de partie inférieure amplifié et le signal de communication de partie supérieure amplifié.

6. Système d'amplification (100) selon l'une quelconque des revendications précédentes, dans lequel l'amplificateur principal (103) ou l'amplificateur secondaire (105) est un amplificateur de classe AB ou un amplificateur de classe B.

7. Système d'amplification (100) selon l'une quelconque des revendications précédentes, dans lequel l'amplificateur auxiliaire (107) est un amplificateur de classe AB, un amplificateur de classe B ou un amplificateur de classe C.

8. Système d'amplification (100) selon l'une quelconque des revendications précédentes, dans lequel l'amplificateur principal (103), l'amplificateur secondaire (105) ou l'amplificateur auxiliaire (107) comprend une paire d'éléments d'amplification, et dans lequel la paire d'éléments d'amplification est connectée en parallèle.

9. Système d'amplification (100) selon l'une quelconque des revendications précédentes, comprenant en outre un coupleur directionnel auxiliaire configuré pour dériver un signal de référence du signal de communication amplifié, dans lequel le processeur (101) est configuré pour comparer le signal de communication de partie supérieure à un signal de comparaison dérivé du signal de référence pour déterminer un retard temporel entre le signal de communication de partie supérieure et le signal de comparaison, et pour retarder le signal de communication de partie supérieure dans le temps sur la base du retard temporel.

10. Système d'amplification (100) selon la revendication 9, comprenant en outre un oscillateur local (301) et un mélangeur auxiliaire (309), dans lequel l'oscillateur local (301) est configuré pour générer un signal de porteuse, et dans lequel le mélangeur auxiliaire (309) est configuré pour multiplier le signal de référence par le signal de porteuse pour obtenir le signal de comparaison.

11. Système d'amplification (100) selon l'une quelconque des revendications précédentes, dans lequel le processeur (101) est configuré pour exécuter un filtrage inverse du signal de communication de partie supérieure sur la base d'une fonction de transfert de l'amplificateur principal (103), d'une fonction de transfert de l'amplificateur secondaire (105) ou d'une fonction de transfert de l'amplificateur auxiliaire (107).

12. Système d'amplification (100) selon l'une quelconque des revendications précédentes, dans lequel le processeur (101) est configuré pour initier une réduction d'une tension d'alimentation de l'amplificateur principal (103) ou de l'amplificateur secondaire (105).

13. Système d'amplification (100) selon l'une quelconque des revendications précédentes, dans lequel le processeur (101) est configuré pour initier une désactivation de l'amplificateur auxiliaire (107).

14. Procédé (200) d'amplification d'un signal de communication, le procédé (200) comprenant :

la comparaison (201) d'amplitudes du signal de communication à un seuil prédéterminé ;
la décomposition (203) du signal de communication en un signal de communication de partie inférieure et un signal de communication de partie supérieure sur la base du seuil prédéterminé, dans lequel le signal de communication de partie inférieure indique des amplitudes du signal de communication inférieures au seuil prédéterminé, et dans lequel le signal de communication de partie supérieure indique des amplitudes du signal de communication supérieures au seuil prédéterminé ;
la décomposition (205) du signal de communication de partie inférieure en un premier sous-signal de communication de partie inférieure et un second sous-signal de communication de partie inférieure, le premier sous-signal de communication de partie inférieure et le second sous-signal de communication de partie inférieure présentant respectivement des amplitudes constantes ;
l'amplification (207) d'un premier signal d'amplificateur dérivé du premier sous-signal de communication de partie inférieure pour obtenir un premier sous-signal de communication de partie inférieure amplifié ;
l'amplification (209) d'un deuxième signal d'amplificateur dérivé du second sous-signal de communication de partie inférieure pour obtenir un second sous-signal de communication de partie inférieure amplifié ;
l'amplification (211) d'un troisième signal d'amplificateur dérivé du signal de communication de partie supérieure pour obtenir un signal de communication de partie supérieure amplifié ;
la combinaison (213) du premier sous-signal de communication de partie inférieure amplifié et du second sous-signal de communication de partie inférieure amplifié pour obtenir un signal de communication de partie inférieure amplifié ; et
la combinaison (215) du signal de communication de partie inférieure amplifié et du signal de communication de partie supérieure amplifié pour obtenir un signal de communication amplifié ;
**caractérisé en ce que** le procédé comprend en outre :
le filtrage du signal de communication de partie inférieure sur la base d'une fonction de transfert de l'amplificateur principal ou d'une fonction de transfert de l'amplificateur secondaire pour obtenir un signal de communication de partie inférieure filtré, la soustraction du signal de communication de partie inférieure filtré du signal de communication de partie inférieure pour obtenir un signal d'erreur, et l'ajout du signal d'erreur au signal de communication de partie supérieure.

15. Programme informatique comprenant un code de programme qui, lorsque le programme est exécuté sur un ordinateur, amène l'ordinateur à exécuter le procédé selon la revendication 14.

Fig. 1

```
┌─────────────────────────────┐
│          Comparing          │─── 201
└─────────────────────────────┘
               │
┌─────────────────────────────┐
│         Decomposing         │─── 203
└─────────────────────────────┘
               │
┌─────────────────────────────┐
│         Decomposing         │─── 205
└─────────────────────────────┘
               │
┌─────────────────────────────┐
│          Amplifying         │─── 207
└─────────────────────────────┘
               │
┌─────────────────────────────┐
│          Amplifying         │─── 209
└─────────────────────────────┘
               │
┌─────────────────────────────┐
│          Amplifying         │─── 211
└─────────────────────────────┘
               │
┌─────────────────────────────┐
│          Combining          │─── 213
└─────────────────────────────┘
               │
┌─────────────────────────────┐
│          Combining          │─── 215
└─────────────────────────────┘
```

200

Fig. 2

Fig. 3

Fig. 4

Fig. 5

Fig. 6

Fig. 7

Fig. 8

Fig. 9

Fig. 10

Fig. 11

Fig. 12

Fig. 13

1401

Fig. 14

32

**EP 3 227 998 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006203673 B